# EUROPÄISCHE PATENTSCHRIFT

(11) **EP 0 933 879 B1**
(45) Veröffentlichungstag und Bekanntmachung des Hinweises auf die Patenterteilung: **08.05.2002**
(21) Anmeldenummer: 99101535.5
(22) Anmeldetag: 29.01.1999
(51) Int. Cl.: H04B 1/04, H03F 3/60, H03G 1/00

(54) **Hochfrequenz-Sender**
Radio frequency transmitter
Emetteur radiofréquence

(30) Priorität: 03.02.1998 DE 19804199
(43) Veröffentlichungstag der Anmeldung: 04.08.1999
(73) Patentinhaber: Rohde & Schwarz GmbH & Co. KG, D-81671 München (DE)
(72) Erfinder: Träger, Robert, 85521 Riemerling (DE); Köhler, Hendrik, 85399 Hallbergmoos (DE)
(74) Vertreter: Graf, Walter, Dipl.-Ing.

(56) Entgegenhaltungen:
- EP-A- 0 481 741
- WO-A-97/41642

## Beschreibung

Die Erfindung betrifft einen Hochfrequenz-Sender mit mehreren Verstärkern laut Oberbegriff des Hauptanspruches.

Hochfrequenz-Sender dieser Art sind bekannt (EP 0 445 139). Als Verstärker werden hierbei jeweils breitbandige Linearverstärker benutzt, die im A-Betrieb arbeiten. Die Einstellung der Soll-Leistung der einzelnen Verstärker erfolgt über entsprechende Steuerung des Ausgangspegels der Erreger. Dazu muß von den Verstärkerausgängen auf die Erreger zurückgegriffen werden. Die Signalverbindungseinrichtung ist bei den bekannten Sendern so ausgebildet, daß zwar bei gleich großer Anzahl von Erregern jeder Verstärker nur mit einem Hochfrequenzssignal beaufschlagt wird, jedoch dann, wenn die Anzahl der Hochfrequenzsignale die Anzahl der Verstärker überschreitet, jeweils zwei Hochfrequenzsignale gleichzeitig über einen Verstärker verstärkt werden.

In der WO-A-97/41642 ist ein Hochfrequenz-Sender offenbart, der aus mehreren geregelten Leistungsverstärkern aufgebaut ist, die eingangsseitig mit Erregern verbunden sind und deren Ausgänge über Kopplungseinrichtungen zusammengefaßt sind. Eine Signalverbindungseinrichtung, mit der die Verstärker eingangsseitig mit den Erregern verbunden sind, ist durch eine Anbindung der Erreger über Leitungen realisiert. Dadurch ist jeweils ein Erreger mit jeweils genau einem Verstärker verbunden. Zur Reduzierung des Stromverbrauchs bei nicht benötigter Verstärkerleistung ist ein spezieller Aufbau der Verstärker durch Zusammenschaltung von Einzelverstärkern vorgeschlagen, bei der das zu verstärkende HF-Signal entweder durch jeden einzelnen Verstärker in Serie geschaltet geleitet wird, oder das Signal nach Durchlaufen des ersten Verstärkers durch Schalter auf einem Bypass an einem oder mehreren der übrigen Einzelverstärker vorbei geleitet wird. Die Steuerspannung der jeweils nicht verwendeten Einzelverstärker wird zur Reduzierung der Leistungsaufnahme abgeschaltet. Der beschriebene Hochfrequenz-Sender hat den Nachteil, daß die Verstärker jeweils einem Erreger fest zugeordnet sind. Verstärker, die zu einem bestimmten Zeitpunkt wegen fehlender Erregersignale ungenutzt sind, können dadurch nicht für andere Erreger genutzt werden.

Es ist Aufgabe der Erfindung, einen Hochfrequenz-Sender dieser Art zu schaffen, dessen Verstärker sehr einfach und preiswert aufgebaut werden können und der universell für die verschiedenartigsten Anwendungsfälle einsetzbar ist.

Diese Aufgabe wird ausgehend von einem Hochfrequenz-Sender laut Oberbegriff des Hauptanspruches durch dessen kennzeichnende Merkmale gelöst. Vorteilhafte Weiterbildungen ergeben sich auch den Unteransprüchen.

Gemäß der Erfindung werden anstelle von A-Linearverstärkern preiswerte geregelte Leistungsverstärker im AB-Betrieb benutzt. Solche AB-Verstärker besitzen den Vorteil, daß sie nicht ständig im Arbeitspunkt ausgesteuert werden und daher im Ruhebetrieb eine wesentlich geringere Leistung aufnehmen als A-Verstärker. Ein A-Verstärker nimmt beispielsweise im Ruhebetrieb eine Leistung von 3000 W auf, während ein AB-Verstärker im Ruhebetrieb nur eine Leistung von 400 W aufnimmt.

Im Gegensatz zum Stand der Technik, nach welchem über einen Verstärker möglichst gleichzeitig mehrere Hochfrequenzsignale verstärkt werden sollen, geht die Erfindung in Kombination mit solchen vorteilhafteren AB-Verstärkern den umgekehrten Weg. Die Signalverbindungseinrichtung ist so ausgebildet und besitzt damit auch nur eine solche Anzahl von Anschlüssen für Erreger, daß jeder Verstärker nie mehr als ein Hochfrequenzsignal eines Erregers verstärkt sondern, wenn möglich, sogar eine geringere Anzahl von Hochfrequenzsignalen auf eine größere Anzahl von Verstärker aufgeteilt wird und dadurch mehrere Verstärker jeweils gleichphasig mit dem gleichen Hochfrequenz-Signal angesteuert werden. Ein weiterer Vorteil des erfindungsgemäßen Senders ist, daß über die leistungsgeregelten AB-Verstärker gleichzeitig auch die Soll-Leistung der einzelnen Verstärker ohne Rückgriff auf die Erreger steuerbar ist. Dadurch können auch Pegelverluste, die in der Signalverbindungseinrichtung durch die einstellungsabhängige, unterschiedliche Dämpfung auftreten, auf einfache Weise kompensiert werden. Dieser Vorteil macht sich besonders bemerkbar in Kombination mit der Maßnahme, die Anzahl der Verstärker möglichst größer zu wählen als die Anzahl der Erreger.

Beim erfindungsgemäßen Sender können über den Benutzer die verschiedenartigsten Betriebsweisen gewählt werden, es können entweder genauso viele Hochfrequenz-Signale wie vorhandene Verstärker jeweils mit unterschiedlicher Frequenz verstärkt werden oder nur ein Hochfrequenz-Signal jeweils mit gleicher Frequenz und gleicher Phase auf eine Vielzahl von einzelnen Verstärkern aufgeteilt werden, dazwischen sind die verschiedenartigsten Kombinationen möglich.

Die Erfindung wird im folgenden anhand schematischer Zeichnungen an einem Ausführungsbeispiel näher erläutert.

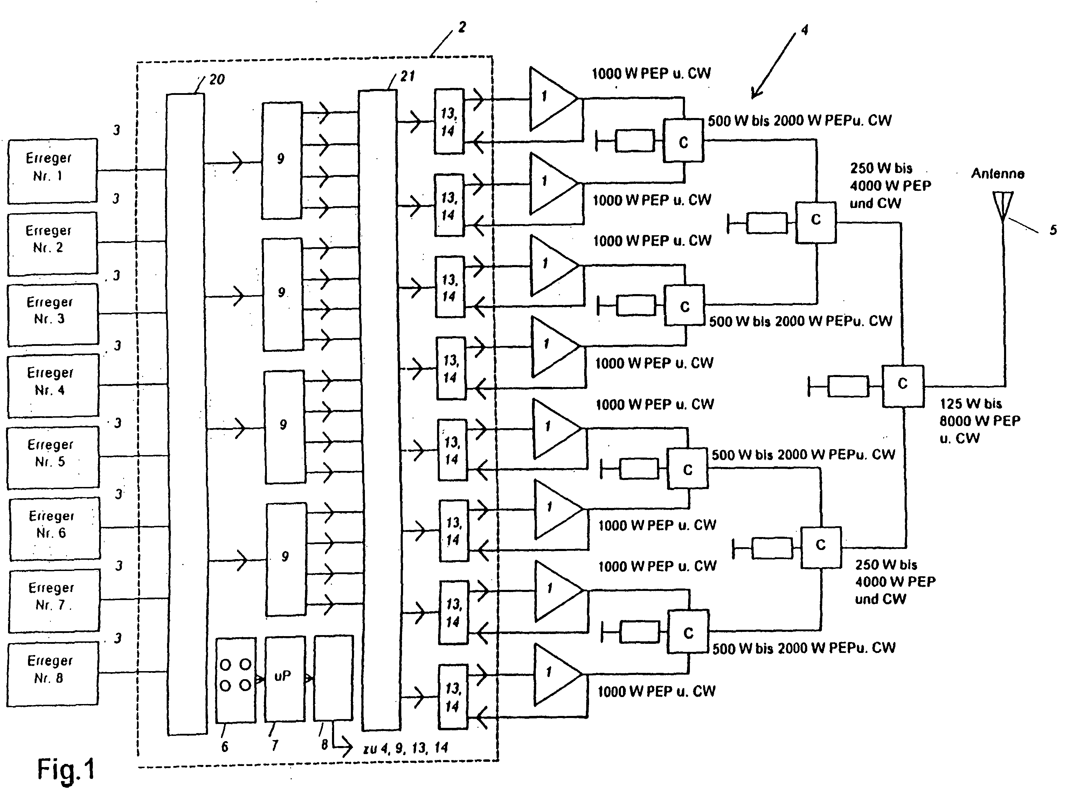

Fig. 1 zeigt das Prinzipschaltbild eines Hochfrequenz-Senders mit acht einzelnen Verstärkern 1 von jeweils 1000 W maximaler Ausgangsleistung, die über eine Signalverbindungseinrichtung 2 mit einem oder mehreren Erregern 3 verbindbar sind. Jeder Erreger 3 liefert an seinem Ausgang ein über den Sender auszusendendes Hochfrequenzsignal. Die Verstärker 1 arbeiten jeweils im AB-Betrieb (siehe beispielsweise
- Zinke, Brunswig, Hartnagel: Lehrbuch der Hochfrequenztechnik, Bd. 2, Springer-Verlag Berlin, 1987,
- Gad, Fricke: Grundlagen der Verstärker, Stuttgart Teubner, 1983,
- Seifart, M: Analoge Schaltungen, 2. Auflage, Heidelberg, Hüthig, 1988 oder
- Voges, E: Hochfrequenztechnik, Bauelemente und Schaltungen, Hüthig.
Solche AB-Verstärker besitzen den Vorteil, daß sie im Ruhebetrieb nur geringe Leistung aufnehmen, ein 1000 W-Verstärker beispielsweise nur 400 W.

Die Ausgänge der Verstärker 1 sind über eine Kopplungseinrichtung 4 mit mehreren 3dB-Kombinierschaltungen C in Form von 3dB-Kopplern in einem gemeinsamen Ausgang zusammengefaßt und speisen eine Antenne 5.

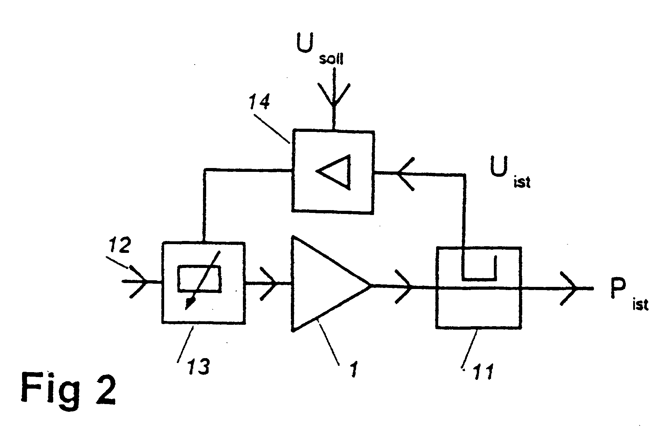

Jeder einzelne AB-Verstärker ist gemäß Fig. 2 aufgebaut, er besteht aus dem eigentlichen im AB-Betrieb angesteuerten Verstärker 1, an dessen Ausgang ein Meßrichtkoppler 11 angeschaltet ist. Das zu verstärkende Eingangangssignal 12 wird über ein verzerrungsarmes spannungsgesteuertes Dämpfungsglied 13 dem Eingang des Verstärkers 1 zugeführt, über den Richtkoppler 11 wird die Ist-Ausgangsleistung des Verstärkers 1 gemessen und zusammen mit der gewünschten Soll-Leistung einem Regelverstärker 14 zugeführt. Über den Ausgang des Regelverstärkers 14 wird das Dämpfungsglied 13 gesteuert. Die Leistung des Verstärkers 1 wird so auf den eingegebenen Leistungssollwert geregelt.

Mit Ausnahme der Meßrichtkoppler 11 sind diese gesamten Regeleinrichtungen für die Verstärker 1 in der Signalverbindungseinrichtung 2 angeordnet, wie dies Fig. 1 zeigt. Dadurch ist es möglich, die Anzahl der Hochfrequenz-Signale geringer als die Anzahl der Verstärker zu wählen. Der Sender kann also in den verschiedenartigsten Betriebsarten eingesetzt werden. Dazu ist in der Signalverbindungseinrichtung 2 eine Einstellvorrichtung 6 vorgesehen, mit welcher der Benutzer diese verschiedenen möglichen Betriebsweisen einstellen kann. Ferner sind die Einstellungen über eine serielle Schnittstelle fernbedienbar. Die Einstellvorrichtung 6 ist mit einem Rechner 7 verbunden, der die gewählte Einstellung in entsprechende Datentelegramme zum Steuern der einzelnen Erregereingänge und Verstärker umsetzt. Dies geschieht über eine Steuerschaltung 8, über die beispielsweise die jeweils erforderlichen Soll-Leistungen für die Regelverstärker 14 der einzelnen Verstärker eingestellt werden. In der Signalverbindungseinrichtung 2 sind außerdem noch vier zusätzliche Leistungsaufteiler 9 vorgesehen, die es ermöglichen, ein ihnen zugeführtes Hochfrequenz-Signal auf zwei, drei oder vier Ausgänge gleichphasig aufzuteilen. Die Eingänge dieser Leistungsaufteiler können über eine schematisch angedeutete Verbindungseinrichtung 20 mit jedem der Erreger 3 verbunden werden, die zwei bis vier aufgeteilten Ausgänge über eine schematisch angedeutete Verbindungseinrichtung 21 mit den jeweils ausgewählten Verstärkern 1.

Mit der so aufgebauten Signalverbindungseinrichtung 2 sind beispielsweise folgende Betriebsweisen möglich:
Einspeisung von acht Hochfrequenzsignalen unterschiedlicher Frequenz aus jeweils acht getrennten Erregern auf jeweils einen der Verstärker und Abstrahlung mit jeweils 125 W,
Einspeisung von nur vier Hochfrequenzsignalen unterschiedlicher Frequenz aus jeweils vier Erregern und Aufteilung jedes Hochfrequenzsignales auf jeweils zwei der Verstärker und somit Abstrahlung mit jeweils 500 W,
Einspeisung von zwei Hochfrequenzsignalen unterschiedlicher Frequenz aus nur zwei Erregern und Aufteilung auf die insgesamt acht Verstärker und damit Abstrahlung jedes Hochfrequenzsignales mit je 2000 W,
Einspeisung nur eines einzigen Hochfrequenzsignales derselben Frequenz aus nur einem Erreger und Aufteilung jeweils gleichphasig auf die insgesamt acht Verstärker und somit Abstrahlung dieses Hochfrequenzsignales mit insgesamt 8000 W,
Einspeisung in beliebig anderen Kombinationen, beispielsweise nur ein Hochfrequenzsignal und Abstrahlung mit 2000 W und gleichzeitig von vier weiteren Hochfrequenzsignalen unterschiedlicher Frequenz mit jeweils 125 W aus insgesamt fünf Erregern oder beispielsweise sechs Hochfrequenzsignale unterschiedlicher Frequenz mit jeweils 125 W und ein Hochfrequenzsignal mit 500 W aus insgesamt sieben Erregern, und dergleichen mehr,
Einspeisung einer geringeren Anzahl von Hochfrequenzsignalen und derartige Aufteilung, daß weniger als acht Verstärker benutzt werden.

Ein großer Vorteil der erfindungsgemäßen Anordnung ist, daß über die Signalverbindungseinrichtung auch nur weniger als acht Verstärker benutzt werden können, so daß beispielsweise ohne Unterbrechung des Senderbetriebes ein oder mehrere gerade nicht benutzte Verstärker ausgebaut und gewartet oder repariert werden können. Ein weiterer Vorteil ist, daß die einzelnen Erreger jeweils einen konstanten Ausgangspegel aufweisen und selbst nicht geregelt sind, da die Leistungseinstellung der Verstärker in der Signalverbindungseinrichtung über die Regelschaltung der Verstärker durchgeführt wird.

## Patentansprüche

1. Hochfrequenz-Sender mit mehreren in ihrer Ausgangsleistung geregelten Verstärkern (1), denen die auszusendenden Hochfrequenz-Signale von mehreren getrennten Erregern (3) über eine Signalverbindungseinrichtung (2) zuführbar sind und deren Ausgänge über eine Kopplungseinrichtung (4) zusammengefaßt sind, wobei die Signalverbindungseinrichtung so ausgebildet ist, daß nie mehr als ein Hochfrequenzsignal an einem der Verstärker (1) anliegt,
**dadurch gekennzeichnet,**
**daß** die Verstärker im AB-Betrieb arbeitende Leistungsverstärker (1) sind und
**daß** je nach gewählter Einstellung einer Einstellvorrichtung (6) über eine Steuerschaltung (8) zwischen nur einem einzigen Erreger (3) bis maximal genausoviel Erregern wie vorhandene Verstärker (1) wahlweise eine beliebige Anzahl von Erregern mit einer beliebigen Anzahl von Verstärkern verbindbar ist und außerdem die Soll-Leistung der Verstärker (1) entsprechend eingestellt wird.

2. Hochfrequenz-Sender nach Anspruch 1,
**dadurch gekennzeichnet,**
**daß** die Steuerschaltung (8) durch einen Rechner (7) angesteuert ist, der durch die Einstellvorrichtung (6) angesteuert ist.

3. Hochfrequenz-Sender nach Anspruch 1 oder 2,
**dadurch gekennzeichnet,**
**daß** je nach gewählter Einstellung der Einstellvorrichtung (6) das Hochfrequenzsignal mindestens eines Erregers (3) gleichphasig auf mindestens zwei Verstärker (1) aufgeteilt wird.

4. Hochfrequenz-Sender nach einem der Ansprüche 1 bis 3,
**dadurch gekennzeichnet,**
**daß** über die Steuerschaltung (8) auch die Kopplungseinrichtung (4) am Ausgang der Verstärker (1) gesteuert ist.

5. Hochfrequenz-Sender nach einem der vorhergehenden Ansprüche,
**dadurch gekennzeichnet,**
**daß** über die Steuerschaltung (8) auch Verbindungseinrichtungen (20, 21) zum Verbinden der Ausgänge der Erreger (3) mit Leistungsaufteilern (9) bzw. zum Durchschalten der Hochfrequenz-Signale zu den Eingängen der Verstärker (1) gesteuert sind.

6. Hochfrequenz-Sender nach einem der vorhergehenden Ansprüche,
**dadurch gekennzeichnet,**
**daß** jeder leistungsgeregelte AB-Verstärker jeweils einen die Ist-Ausgangsleistung messenden Detektor (11), einen diese Ist-Leistung mit einer vorgewählten Soll-Leistung vergleichenden Regelverstärker (14) und ein damit gesteuertes Stellglied (13) am Eingang des Verstärkers aufweist.

## Claims

1. Radio-frequency transmitter with several amplifiers (1) of controlled output power to which the radio-frequency signals to be transmitted from several separate exciters (3) can be supplied through a signal connection device (2) and whose outputs are combined through a coupling device (4), the signal connection device being designed so that there is never more than one radio-frequency signal applied to one of the amplifiers (1),
**characterized in that** the amplifiers are power amplifiers (1) operating in AB mode and, depending on a selected setting of an adjusting device (6), through a control circuit (8), any number of exciters, from a single exciter (3) only up to a maximum of as many exciters as existing amplifiers (1), can be optionally connected to any number of amplifiers and the setpoint power of the amplifiers (1) is also set accordingly.

2. Radio-frequency transmitter according to Claim 1, **characterized in that** the control circuit (8) is controlled by a computer (7) which is controlled by the adjusting device (6).

3. Radio-frequency transmitter according to either of Claims 1 or 2, **characterized in that**, depending on a selected setting of the adjusting device (6), the radio-frequency signal of at least one exciter (3) is distributed co-phasally to at least two amplifiers (1).

4. Radio frequency transmitter according to any one of Claims 1 to 3, **characterized in that** the coupling device (4) at the output of the amplifiers (1) is also controlled through the control circuit (8).

5. Radio-frequency transmitter according to any one of the preceding Claims, **characterized in that** connection devices (20, 21) for connecting the outputs of the exciters (3) to power distributors (9) and/or for connecting the radio-frequency signals through to the inputs of the amplifiers (1) are also controlled through the control circuit (8).

6. Radio-frequency transmitter according to any one of the preceding Claims, **characterized in that** each power-controlled AB amplifier comprises a respective detector (11), measuring the actual output power, a regulating amplifier (14), comparing this actual power with a preselected setpoint power, and an actuator (13), controlled by it, at the input of the amplifier.

## Revendications

1. Émetteur radiofréquence avec plusieurs amplificateurs (1) contrôlés dans leur puissance de sortie auxquels les signaux radiofréquence à envoyer peuvent être menés depuis plusieurs excitateurs (3) distincts en passant par un dispositif de combinaison des signaux (2) et dont les sorties sont rassemblées au moyen d'un dispositif de couplage (4), dans lequel le dispositif de combinaison des signaux est constitué de telle sorte qu'il n'y ait jamais plus d'un signal radiofréquence qui atteigne un amplificateur (1)
**caractérisé en ce que**
les amplificateurs sont des amplificateurs (1) de puissance fonctionnant en classe AB et
que selon le réglage sélectionné d'un dispositif de réglage (6) au moyen d'un commutateur de commande (8) compris entre un seul excitateur (3) ou jusqu'à un nombre d'excitateurs au plus égal au nombre d'amplificateurs (1) on peut au choix relier un nombre quelconque d'excitateurs avec un nombre quelconque d'amplificateurs et qu'en outre la puissance théorique des amplificateurs est réglée en conséquence.

2. Émetteur radiofréquence selon la revendication 1
**caractérisé en ce que**
le commutateur de commande (8) est commandé par un ordinateur (7) lequel est commandé par le dispositif de réglage (6).

3. Émetteur radiofréquence selon la revendication 1 ou 2
**caractérisé en ce que**
selon le réglage choisi du dispositif de réglage (6) le signal radiofréquence d'au moins un excitateur est réparti en phase sur au moins deux amplificateurs.

4. Émetteur radiofréquence selon l'une des revendications 1 à 3
**caractérisé en ce que**
le commutateur de commande (8) commande aussi le dispositif de couplage (4) situé à la sortie de l'amplificateur (1).

5. Émetteur radiofréquence selon l'une des revendications précédentes
**caractérisé en ce que**
le commutateur de commande (8) commande aussi les dispositifs de combinaison (20, 21) qui servent à relier les sorties des excitateurs (3) à des répartiteurs de puissance (9) ou à connecter les signaux radiofréquence aux entrées des amplificateurs (1).

6. Émetteur radiofréquence selon l'une des revendications précédentes
**caractérisé en ce que**
chacun des amplificateurs fonctionnant en classe AB contrôlé pour ce qui est de la puissance présente à l'entrée de l'amplificateur un détecteur (11) mesurant la puissance de sortie effective, un amplificateur de contrôle (14) comparant cette puissance effective avec une puissance théorique présélectionnée et un composant de réglage (13) commandé par ce dispositif.
